# FASCICULE DE BREVET EUROPEEN

(11) **EP 2 875 529 B1**
(45) Date de publication et mention de la délivrance du brevet: **19.06.2019**
(21) Numéro de dépôt: 13741997.4
(22) Date de dépôt: 19.07.2013
(51) Int. Cl.: H01L 29/861, H01L 49/02, G11C 11/56, H01L 49/00, H01L 27/11507, G11C 11/22

(54) **DISPOSITIF COMPORTANT UNE PLURALITÉ DE COUCHES MINCES**
VORRICHTUNG MIT EINER VIELZAHL VON DÜNNEN SCHICHTEN
DEVICE COMPRISING A PLURALITY OF THIN LAYERS

(30) Priorité: 20.07.2012 FR 1202071
(43) Date de publication de la demande: 27.05.2015
(73) Titulaire: THALES, 92200 Neuilly-sur-Seine (FR); Centre National de la Recherche Scientifique (C.N.R.S.), 75016 Paris (FR); Université Paris-Sud 11, 91405 Orsay (FR)
(72) Inventeur: BIBES, Manuel, F-75013 Paris (FR); BARTHELEMY, Agnes, F-91640 Janvry (FR)
(74) Mandataire: Lavoix
(86) Numéro de dépôt international: PCT/EP2013/065278
(87) Numéro de publication internationale: WO 2014/013052

(56) Documents cités:
- EP-A2- 1 333 471
- US-A1- 2003 030 084
- US-A1- 2008 081 380

## Description

La présente invention concerne un dispositif comportant une pluralité de couches minces, appartenant au domaine des hétérostructures à couches minces utilisées dans les composants microélectroniques, à la fois pour le stockage d'informations et pour le traitement d'informations.

Plus particulièrement, l'invention s'inscrit dans le domaine des mémoires ferroélectriques non-volatiles à accès aléatoire (FeRAM).

Dans le domaine des mémoires non-volatiles à accès aléatoire (RAM), il serait désirable d'avoir un élément à deux terminaux utilisable pour l'écriture et la lecture d'information, de lecture non destructive, miniaturisable à volonté, faiblement consommateur d'énergie en lecture et en écriture, et possédant des temps de lecture et d'écriture les plus courts possibles, et de très grande endurance. Les technologies existantes ne permettent pas d'atteindre simultanément l'ensemble des caractéristiques précitées.

Une approche émergeante prometteuse s'appuie sur l'effet d'électrorésistance tunnel observée dans des hétérostructures minces tri-couches, constituées de deux couches conductrices formant des électrodes séparées d'une couche mince en matériau isolant ferroélectrique utilisée comme barrière tunnel. Ces hétérostructures sont connues sous le nom de « jonctions tunnel ferroélectriques » et sont utilisées dans les mémoires FeRAM. En dessous de la température de Curie de la barrière tunnel ferroélectrique, une polarisation rémanente peut y être induite. La direction de polarisation est déterminée selon le champ électrique qui est appliqué à la couche ferroélectrique. L'application d'une tension électrique positive ou négative supérieure à une tension seuil permet de modifier la direction de polarisation. Chaque direction de polarisation permet d'encoder une information. Par exemple, avec deux directions de polarisation opposées une information binaire (0 ou 1) peut être stockée.

Dans une jonction tunnel ferroélectrique, le courant à travers la barrière tunnel ferroélectrique diffère selon la direction de polarisation ferroélectrique, chaque courant correspondant à une valeur de résistance tunnel. Il s'agit de l'effet d'électrorésistance tunnel. On peut qualifier le comportement de la jonction ferroélectrique par le rapport des résistances tunnel correspondant à des directions de polarisation différentes, par exemple opposées, ou rapport « off-on ». L'information stockée est lue par la valeur de la résistance mesurée sous l'application d'une tension inférieure à la tension seuil.

Dans l'état de la technique, comme par exemple dans le brevet US7759713 décrivant un élément à tunnel ferroélectrique et son application comme élément mémoire non-volatile dans le domaine de la microélectronique, ce rapport atteint des valeurs entre 100 et 1000.

Le document US20060145225 décrit un élément de mémoire ferroélectrique (FeRAM) formé de deux couches conductrices formant des électrodes entre lesquelles sont placées une couche ferroélectrique dont la direction de polarisation peut être renversée et une couche non ferroélectrique qui a pour effet de faciliter la lecture de la polarisation, qui fournit la valeur de l'information stockée. Dans cet état de la technique, le rapport des résistances tunnel est de l'ordre de 10 à 100.

Les documents EP 1 333 471 A2, US2003/0030084 A1 et US 2008/0081380 décrivent des dispositifs multi-couches comportant une pluralité de couches minces, avec une couche ferroélectrique dont la direction de polarisation peut être renversée située entre des couches conductrices formant des électrodes.

Pour certaines applications, il est cependant désirable d'obtenir un rapport des résistances tunnel bien supérieur à 1000.

Par exemple, lorsque les jonctions tunnel ferroélectriques sont utilisées comme points mémoires dans des matrices de type « cross-bar arrays », le rapport « off-on » doit être supérieur au nombre de points de la matrice. Dans ce cas, il est particulièrement intéressant d'obtenir un rapport « off-on » bien supérieur à 1000, pour permettre l'intégration d'un grand nombre de points mémoire dans la matrice.

On connaît également dans l'état de la technique une autre sorte d'hétérostructure formée de nanostructures électrorésistives, à base d'oxydes comme TiO₂ ou SrTiO₃ ou de composé à base d'Ag et de Si. Pour ce type de structures, des rapports « off-on » supérieurs à 10000 ont été rapportés, comme mentionné par exemple dans l'article de Jo et al, "High-Density Crossbar Arrays Based on a Si Memristive System" publié dans Nano Letters 9, pages 870-874, année 2009. Cependant, les différents niveaux de résistance correspondent pour ces hétérostructures à différentes distributions spatiales d'ions, d'atomes ou de défauts comme des lacunes d'oxygène. Leur fonctionnement repose sur l'effet d'électromigration d'ions ou d'atomes, ce qui implique des températures de fonctionnement élevées et une vitesse de fonctionnement faible puisque liée à la mobilité des ions ou des atomes.

Il est donc souhaitable d'obtenir un dispositif comportant une pluralité de couches minces de type jonction tunnel ferroélectrique, ayant un rapport de résistances tunnel élevé, tout en ayant une bonne vitesse de fonctionnement.

A cet effet, l'invention propose, selon un premier aspect, un dispositif comportant une pluralité de couches minces selon la revendication 1.

Le dispositif à couches minces selon l'invention forme une jonction tunnel ferroélectrique, à barrière d'épaisseur variable.

Avantageusement, une couche intermédiaire permet d'amplifier le rapport des résistances tunnel, cette couche intermédiaire étant soit une barrière tunnel additionnelle, soit un prolongement de l'électrode adjacente. Grâce à la caractéristique selon laquelle des propriétés électroniques de la couche intermédiaire sont modifiées selon la direction de polarisation dans ladite couche de matériau ferroélectrique adjacente, en pratique, l'épaisseur et/ou la hauteur moyenne de la barrière est contrôlée par la direction de polarisation. Or le courant tunnel diminue exponentiellement avec l'épaisseur de la barrière, et par conséquent de fortes différences de résistance sont générées.

De plus, comme l'effet d'électrorésistance tunnel dans les jonctions tunnel ferroélectriques est lié au renversement de la polarisation ferroélectrique dans la barrière, donc dépend des positions atomiques au sein de chaque maille unité du matériau formant la barrière tunnel, mais non des redistributions spatiales des atomes ou des ions comme dans les éléments à base de dioxyde de Titane TiO₂ ou de titanate de strontium SrTiO₃, des vitesses de fonctionnement bien supérieures, de l'ordre du giga Hertz (GHz), sont atteignables.

Le dispositif à couches minces peut également présenter une ou plusieurs des caractéristiques ci-dessous :
- la modification des propriétés électroniques de la couche intermédiaire est obtenue par la variation de la densité de porteurs dans ladite couche intermédiaire ;
- ladite couche intermédiaire est constituée d'un matériau présentant une transition métal-isolant en fonction du nombre de porteurs ;
- ladite couche intermédiaire est constituée d'un matériau pérovskite parmi les suivants : pérovskite de Titane de formule A₁₋ₓA'ₓTiO₃, où A et A' sont des ions 3+ différents, x variant entre 0 et 1 ; pérovskite de Titane de formule A₁₋ₓBₓTiO₃, où A est un ion 3+, B est un ion 2+, x variant entre 0 et 1 ; pérovskite de Vanadium, de formule A₁₋ₓ BₓVO₃, où A est un ion 3+, B est un ion 2+, x variant entre 0 et 1 ; pérovskite de Cobalt, de formule A₁₋ₓBₓCoO₃, où A est un ion 3+, B est un ion 2+, x variant entre 0 et 1 ; et

Selon un second aspect, l'invention concerne l'utilisation d'un dispositif tel que brièvement décrit ci-dessus comme élément mémoire d'une mémoire non-volatile, dans lequel une information est écrite par l'application d'une tension électrique supérieure en valeur absolue à une tension seuil à la couche de matériau ferroélectrique.

Selon un troisième aspect, l'invention concerne l'utilisation d'un dispositif tel que brièvement décrit ci-dessus comme élément d'un circuit logique programmable par l'application d'une tension électrique supérieure en valeur absolue à une tension seuil à la couche de matériau ferroélectrique.

Selon un quatrième aspect, l'invention concerne l'utilisation d'un dispositif tel que brièvement décrit ci-dessus comme micro-interrupteur par l'application d'une tension électrique supérieure en valeur absolue à une tension seuil à la couche de matériau ferroélectrique.

D'autres caractéristiques et avantages de l'invention ressortiront de la description qui en est donnée ci-dessous, à titre indicatif et nullement limitatif, en référence aux figures annexées, parmi lesquelles :
- la figure 1 représente un dispositif à couches minces selon l'invention ;
- la figure 2 représente un exemple de dispositif à couches minces avec couche intermédiaire conductrice et un profil de potentiel associé ;
- la figure 3 représente un exemple de dispositif à couches minces avec couche intermédiaire isolante et un profil de potentiel associé ;
- la figure 4 représente un exemple de dispositif à couches minces avec couche intermédiaire à faible largeur de bande interdite et un profil de potentiel associé, et
- la figure 5 représente un exemple de dispositif à couches minces avec couche intermédiaire à forte largeur de bande interdite et un profil de potentiel associé.

L'invention sera décrite pour un dispositif à couches minces formant une jonction tunnel ferroélectrique, comprenant une couche intermédiaire supplémentaire, et son utilisation dans un élément mémoire non-volatile, un élément de circuit logique programmable ou un micro-interrupteur. Néanmoins, l'invention s'applique de manière analogue avec d'autres agencements de couches, par exemple avec deux couches intermédiaires ajoutées de part et d'autre de la couche formant une barrière tunnel ferroélectrique.

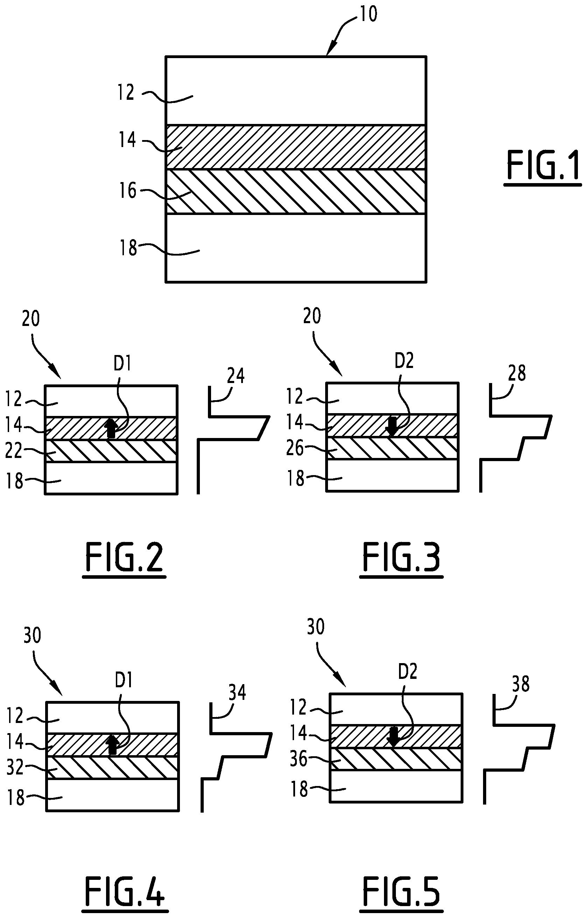

La figure 1 représente un dispositif à couches minces formant une jonction tunnel ferroélectrique 10 selon l'invention, composé d'une pluralité de couches : une première couche conductrice 12, une couche en matériau ferroélectrique formant une barrière tunnel ferroélectrique 14, une couche mince intermédiaire 16, qui est constituée d'un matériau dont les propriétés électroniques sont modifiées selon la direction de polarisation dans la couche ferroélectrique 14 adjacente et une deuxième couche conductrice 18. Les deux couches conductrices 12 et 18 positionnées aux extrémités de l'élément forment des électrodes.

Dans le mode de réalisation de la figure 1, la couche intermédiaire 16 a de préférence une épaisseur comprise dans une plage de 0,1 à 10 nanomètres (nm), la couche barrière tunnel ferroélectrique 14 ayant une épaisseur dans une plage de 0,1 à 10nm également et les électrodes 12, 18 ayant des épaisseurs dans une plage de 0,1 à 500 nm.

En termes de matériaux employés, les électrodes 12, 18 sont soit des métaux, soit des semi-conducteurs appartenant à différentes familles, par exemple des métaux simples comme l'Au, le Ru ou le Pt, des oxydes métalliques comme le SrRuO₃ ou le (La,Sr)MnO₃, des semi-conducteurs comme le Si, le GaAs ou d'autres composés III-V (semi-conducteurs composés d'un ou plusieurs éléments de la colonne III de la table périodique des éléments et d'un ou plusieurs éléments de la colonne V de cette table), des oxydes semi-conducteurs comme ZnO, ITO ou SrTiO₃, ou des conducteurs organiques. Ils pourront être de type N ou de type P.

La barrière tunnel ferroélectrique 14 est constituée d'un matériau ferroélectrique inorganique, par exemple BaTiO₃, Pb(Zr,Ti)O₃, BiFeO₃, SBT, SBN, ou organique.

Les propriétés électroniques du matériau formant la couche mince intermédiaire 16 sont modifiables selon la direction de polarisation ferroélectrique dans la couche adjacente.

Dans un mode de réalisation, une telle modification des propriétés électroniques de la couche intermédiaire 16 est obtenue par la variation de la densité de porteurs dans cette couche.

Dans le mode de réalisation préféré, le matériau de la couche mince intermédiaire 16 présente une transition métal-isolant en fonction du nombre de porteurs, par exemple un isolant de Mott, présent dans plusieurs familles d'oxydes de métaux de transition.

De façon non exhaustive, les matériaux envisagés sont :
- certains nickelates : PrNiO₃, NdNiO₃, SmNiO₃, EuNiO₃, GdNiO₃, TbNiO₃, DyNiO₃, HoNiO₃, ErNiO₃, TmTiO₃, YbNiO₃, LuNiO₃, YNiO₃ ou leurs solutions solides ;
- certaines manganites de la forme A₁₋ₓBₓMnO₃ où A est un ion 3+ tel que La³⁺, Pr³⁺, Nd³⁺, Sm³⁺, Eu³⁺, Gd³+, Tb³⁺, Dy³⁺, Ho³⁺, Er³⁺, Tm³⁺, Yb³⁺, Lu³⁺, Y³⁺ ou un ion 4+ tel que Ce⁴⁺ et B un ion 2+ tel que Ca²⁺, Sr²⁺ ou Ba²⁺, x variant entre 0 et 1 ;
- certaines pérovskites de Ti de formule :
   - A₁₋ₓA'ₓTiO₃, où A et A' sont des ions 3+ différents, A étant par exemple La³⁺ et A' étant par exemple Y³⁺, Ho³⁺, Er³⁺, Tm³⁺, Yb³⁺, Lu³⁺, x variant entre 0 et 1 ;
   - A₁₋ₓ BₓTiO₃, où A est un ion 3+ tel que La³⁺, Pr³⁺, Nd³⁺, Sm³⁺, Eu³⁺, Gd³+, Tb³⁺, Dy³⁺, Ho³⁺, Er³⁺, Tm³⁺, Yb³⁺, Lu³⁺, Y³⁺ et B un ion 2+ tel que Ca²⁺, Sr²⁺ ou Ba²⁺, x variant entre 0 et 1 ;
- certaines pérovskites de V, de la forme A₁₋ₓ BₓVO₃ où A est un ion 3+ tel que La³⁺, Pr³⁺, Nd³⁺, Sm³⁺, Eu³⁺, Gd³+, Tb³⁺, Dy³⁺, Ho³⁺, Er³⁺, Tm³⁺, Yb³⁺, Lu³⁺, Y³⁺ et B un ion 2+ tel que Ca²⁺, Sr²⁺ ou Ba²⁺, x variant entre 0 et 1 ;
- certaines pérovskites de Co de la forme A₁₋ₓBₓCoO₃ où A est un ion 3+ tel que La³⁺, Pr³⁺, Nd³⁺, Sm³⁺, Eu³⁺, Gd³+, Tb³⁺, Dy³⁺, Ho³⁺, Er³⁺, Tm³⁺, Yb³⁺, Lu³⁺, Y³⁺ et B un ion 2+ tel que Ca²⁺, Sr²⁺ ou Ba²⁺, x variant entre 0 et 1 ;
- certaines solutions solides de SrRuO₃ et SrTiO₃ ;
- les oxydes de V tels que VO₂ ou V₂O₃, éventuellement dopés en Ti ou Cr.

De façon classique, un dispositif à couches minces 10 est élaboré par une technique de croissance ou plusieurs techniques de croissance combinées, telle que l'ablation laser puisée, la pulvérisation cathodique, le dépôt chimique en phase vapeur ou l'évaporation.

Le rôle de la couche intermédiaire 16 sera plus particulièrement décrit maintenant dans un premier mode de réalisation en référence aux figures 2 et 3.

Dans ce mode de réalisation, le dispositif à couches minces formant jonction tunnel ferroélectrique 20 selon l'invention comporte une couche intermédiaire dont les propriétés de conductivité changent selon la direction de polarisation dans la couche ferroélectrique adjacente.

Dans l'exemple de la figure 2, la couche intermédiaire 16 se comporte en matériau conducteur 22 lorsque la couche ferroélectrique 14 est polarisée selon une première direction D1 représentée par une flèche. Ici, la couche intermédiaire 22 joue le rôle d'une électrode laissant passer le courant, comme illustré dans le profil schématique de potentiel 24 correspondant au courant traversant le dispositif 20: le potentiel est constant à une valeur nominale donnée à travers les couches 18 et 22, qui sont toutes deux conductrices, puis il subit une variation importante en traversant la couche ferroélectrique 14 et revient à une valeur proche de la valeur nominale. La différence de potentiel entre les couches 12 et 18 est préférentiellement comprise entre 1 et 500mV.

Dans l'exemple de la figure 3, la direction de polarisation D2 dans la couche ferroélectrique 14 est opposée à la direction de polarisation D1 de l'exemple de la figure 2. La couche intermédiaire 16 se comporte en matériau isolant 26, jouant le rôle de barrière tunnel supplémentaire. Les électrons doivent alors traverser une barrière tunnel composite ou hybride, formée des couches 14 et 26, dont l'épaisseur est donc supérieure à l'épaisseur de la barrière tunnel ferroélectrique 14. Le profil schématique de potentiel 28 correspondant au courant traversant l'élément 20 illustre ce fonctionnement : le potentiel est constant à une valeur nominale donnée à travers la couche conductrice 18, puis il subit une première variation en traversant la couche isolante 26, puis une seconde variation en traversant la couche ferroélectrique 14 et revient à une valeur proche de la valeur nominale à travers la couche conductrice 12.

Le courant tunnel diminue exponentiellement avec l'épaisseur de la barrière. Par exemple, un rapport de résistance « off-on » de l'ordre de 1000 ou plus est atteint avec une couche intermédiaire d'épaisseur 2 nm dont la conductivité change avec la polarisation de la couche ferroélectrique d'épaisseur 2 nm adjacente.

Dans un autre mode de réalisation, illustré dans les figures 4 et 5, le dispositif à couches minces formant jonction tunnel ferroélectrique 30 selon l'invention comporte une couche intermédiaire dont la largeur de bande interdite (« band gap ») varie en fonction de la direction de polarisation dans la couche ferroélectrique 14 adjacente. Par exemple, la couche intermédiaire est constituée de VO₂

Dans l'exemple de la figure 4, lorsque la direction de polarisation de la couche ferroélectrique 14 est la direction D1, la largeur de bande interdite de la couche intermédiaire est faible (similaire par exemple au nickelate de samarium SmNiO₃), ce qui permet à la couche intermédiaire de se comporter comme un matériau 32 faiblement conducteur, comme cela est illustré sur le profil schématique de potentiel 34 correspondant au courant traversant le dispositif 30.

Dans l'exemple de la figure 5, la direction de polarisation D2 dans la couche ferroélectrique 14 est opposée à la direction de polarisation D1 de l'exemple de la figure 4. La couche intermédiaire 16 se comporte en matériau 36 à large bande interdite (similaire par exemple au titanate de strontium SrTiO₃), jouant ainsi le rôle de barrière tunnel également.

Le profil schématique de potentiel 38 correspondant au courant traversant le dispositif 30 illustre ce fonctionnement, qui est similaire au fonctionnement illustré en figure 3 dans lequel la couche intermédiaire 16 se comporte en matériau isolant 26.

Ainsi, dans le mode de réalisation illustré dans les figures 4 et 5, la couche intermédiaire 16 joue un rôle de barrière tunnel additionnelle, de hauteur variable selon la direction de polarisation. En particulier, comme illustré à la figure 5, l'épaisseur de la barrière tunnel est égale à l'épaisseur de la couche 14 plus l'épaisseur de la couche 36, ce qui permet de diminuer fortement le courant tunnel et donc d'augmenter le niveau de résistance associé.

Le dispositif à couches minces selon l'invention trouve une première application comme élément de mémoire non-volatile dans une mémoire de type FeRAM. L'information, par exemple une information binaire, est écrite par application d'une tension supérieure, en valeur absolue, à une tension seuil qui est déterminée en fonction des matériaux composant les diverses couches, qui a pour effet de renverser la direction de polarisation de la couche ferroélectrique. L'inversion de la direction de polarisation permet typiquement de stocker une information binaire (0 ou 1). Une fois la tension coupée, ou sous application d'une tension plus faible, la direction de la polarisation est stable. Pour lire l'information stockée, une valeur de résistance est mesurée sous application d'une tension inférieure à la tension de seuil.

Le dispositif à couches minces selon l'invention trouve une deuxième application comme élément d'un circuit logique programmable, par application d'une tension supérieure, en valeur absolue, à une tension seuil, pour inscrire une information binaire dans le circuit.

Le dispositif à couches minces selon l'invention trouve une troisième application comme micro-interrupteur contrôlable dans un micro-circuit destiné au traitement logique de l'information, grâce au rapport de résistances tunnel « off-on » très élevé, permettant de s'assurer que dans l'état « off », un courant négligeable circule dans le circuit contrôlé par le micro-interrupteur, et qu'il peut donc être considéré comme ouvert.

## Revendications

1. Dispositif comportant une pluralité de couches minces (12, 14, 18) comprenant une couche (14) formée d'un matériau ferroélectrique polarisable selon plusieurs directions de polarisation selon une tension électrique appliquée à ladite couche de matériau ferroélectrique et formant une barrière tunnel ferroélectrique, entourée d'une paire de couches conductrices (12, 18) formant des électrodes, ledit dispositif comprend une couche intermédiaire (16, 22, 26, 32, 36) entre ladite couche (14) de matériau ferroélectrique et une des couches conductrices (12, 18), ladite couche intermédiaire (16, 22, 26, 32, 36) étant constituée d'un matériau dont des propriétés électroniques de conductivité ou de largeur de bande interdite sont modifiées selon la direction de polarisation dans ladite couche (14) de matériau ferroélectrique adjacente, permettant de réaliser un dispositif à barrière tunnel ferroélectrique d'épaisseur variable, la couche intermédiaire (16) possédant une épaisseur comprise entre 0,1 nanomètres et 10 nanomètres.

2. Dispositif selon la revendication 1, **caractérisé en ce que** la modification des propriétés électroniques de la couche intermédiaire (16) est obtenue par la variation de la densité de porteurs dans ladite couche intermédiaire.

3. Dispositif selon la revendication 2, **caractérisé en ce que** ladite couche intermédiaire (14) est constituée d'un matériau présentant une transition métal-isolant en fonction du nombre de porteurs.

4. Dispositif selon la revendication 3, **caractérisé en ce que** ladite couche intermédiaire est constituée d'un matériau pérovskite parmi les suivants : pérovskite de Titane de formule A₁₋ₓA'ₓTiO₃, où A et A' sont des ions 3+ différents, x variant entre 0 et 1 ; pérovskite de Titane de formule A₁₋ₓBₓTiO₃, où A est un ion 3+, B est un ion 2+, x variant entre 0 et 1 ; pérovskite de Vanadium, de formule A₁₋ₓ BₓVO₃, où A est un ion 3+, B est un ion 2+, x variant entre 0 et 1 ; pérovskite de Cobalt, de formule A₁₋ₓBₓCoO₃, où A est un ion 3+, B est un ion 2+, x variant entre 0 et 1.

5. Utilisation d'un dispositif selon l'une quelconque des revendications 1 à 4 comme élément mémoire d'une mémoire non-volatile, dans lequel une information est écrite par l'application d'une tension électrique supérieure en valeur absolue à une tension seuil à la couche de matériau ferroélectrique.

6. Utilisation d'un dispositif selon l'une quelconque des revendications 1 à 4 comme élément d'un circuit logique programmable par l'application d'une tension électrique supérieure en valeur absolue à une tension seuil à la couche de matériau ferroélectrique.

7. Utilisation d'un dispositif selon l'une quelconque des revendications 1 à 4 comme micro-interrupteur par l'application d'une tension électrique supérieure en valeur absolue à une tension seuil à la couche de matériau ferroélectrique.

## Patentansprüche

1. Vorrichtung (10), die eine Mehrzahl von dünnen Schichten (12, 14, 18) aufweist, aufweisend eine Schicht (14), gebildet aus ferroelektrischen Material, das in mehreren Polarisationsrichtungen gemäß einer an die ferroelektrische Materialschicht angelegten elektrischen Spannung polarisierbar ist, und eine Ferroelektrischer-Tunnel-Barriere bildend, umgeben von einem Paar leitender Schichten (12, 18), die Elektroden bilden, wobei die Vorrichtung eine Zwischenschicht (16, 22, 26, 32, 36) zwischen der Schicht (14) aus ferroelektrischem Material und einer der leitfähigen Schichten (12, 18) aufweist, wobei die Zwischenschicht (16, 22, 26, 32, 36) aus einem Material gebildet ist, dessen elektronische Eigenschaften der Leitfähigkeit oder der Größe des verbotenen Bands gemäß der Polarisationsrichtung in der Schicht (14) aus benachbartem ferroelektrischem Material modifiziert sind, ermöglichend, eine Vorrichtung mit Ferroelektrischer-Tunnel-Barriere mit variabler Dicke zu realisieren, wobei die Zwischenschicht (16) eine Dicke hat, die zwischen 0,1 Nanometern und 10 Nanometern liegt.

2. Vorrichtung nach Anspruch 1, **dadurch gekennzeichnet, dass** die Veränderung der elektronischen Eigenschaften der Zwischenschicht (16) durch Variieren der Ladungsträgerdichte in der Zwischenschicht erhalten wird.

3. Vorrichtung nach Anspruch 2, **dadurch gekennzeichnet, dass** die Zwischenschicht (14) aus einem Material gebildet ist, das in Abhängigkeit von der Anzahl der Träger einen Metall-Isolator-Übergang aufweist.

4. Vorrichtung nach Anspruch 5, **dadurch gekennzeichnet, dass** die Zwischenschicht aus einem Perowskitmaterial unter den Folgenden besteht: Titanperowskit mit der Formel A₁₋ₓA'ₓTiO₃, wobei A und A' unterschiedliche 3+ - Ionen sind, wobei x zwischen 0 und 1 variiert; Titanperowskit mit der Formel A₁₋ₓBₓTiO₃, wobei A ein 3+ -Ion ist, B ein 2+ -Ion ist und x zwischen 0 und 1 variiert; Vanadiumperowskit mit der Formel A₁₋ₓBₓVO₃, wobei A ein 3+ -Ion ist, B ein 2+ -Ion ist und x zwischen 0 und 1 variiert; Kobaltperowskit mit der Formel A₁₋ₓBₓCoO₃, wobei A ein 3+ -Ion ist, B ein 2+ -Ion ist und x zwischen 0 und 1 variiert.

5. Verwendung einer Vorrichtung nach einem der Ansprüche 1 bis 4 als Speicherelement eines nichtflüchtigen Speichers, in dem eine Information geschrieben wird durch Anlegen einer elektrischen Spannung, deren Absolutwert höher ist als eine Schwellenspannung, an die ferroelektrische Materialschicht.

6. Verwendung einer Vorrichtung nach einem der Ansprüche 1 bis 4 als Element einer Logikschaltung, programmierbar durch Anlegen einer elektrischen Spannung, deren Absolutwert höher ist als eine Schwellenspannung, an die ferroelektrische Materialschicht.

7. Verwendung einer Vorrichtung nach einem der Ansprüche 1 bis 4 als Mikroschalter durch Anlegen einer elektrischen Spannung, deren Absolutwert höher ist als eine Schwellenspannung, an die ferroelektrische Materialschicht.

## Claims

1. A device including a plurality of thin layers (12, 14, 18) comprising a layer (14) formed with a polarizable ferroelectric material according to several directions of polarization according to an electric voltage applied to said ferroelectric material layer and forming a ferroelectric tunnel barrier, surrounded by a pair of conductive layers (12, 18) forming electrodes, said device comprises an intermediate layer (16, 22, 26, 32, 36) between said layer (14) of ferroelectric material and one of the conductive layers (12, 18), said intermediate layer (16, 22, 26, 32, 36) consisting of a material for which the electronic properties of conductivity or band gap width are modified according to the direction of polarization in said adjacent ferroelectric material layer (14), so as to achieve a device with a variable width ferroelectric tunnel barrier, said intermediate layer (16) having a thickness comprised between 0.1 nm and 10 nm.

2. The device according to claim 1, **characterized in that** the modification of the electronic properties of the intermediate layer (16) is obtained by the variation of the density of carriers in said intermediate layer.

3. The device according to claim 2, **characterized in that** said intermediate layer (14) consists of a material having a metal-insulated transition depending on the number of carriers.

4. The device according to claim 3, **characterized in that** said intermediate layer consists of perovskite material from among the following: titanium perovskite of formula A₁₋ₓA'ₓTiO₃, wherein A and A' are different 3+ ions, x varying between 0 and 1, titanium perovskite of formula A₁₋ₓBₓTiO₃, wherein A is a 3+ ion, B is a 2+ ion, x varying between 0 and 1; vanadium perovskite of formula A₁₋ₓBₓVO₃, wherein A is a 3+ ion, B is a 2+ ion, x varying between 0 and 1; cobalt perovskite of formula A₁₋ₓBₓCoO₃, wherein A is a 3+ ion, B is a 2+ ion, x varying between 0 and 1.

5. The use of a device according to any of claims 1 to 4, as a memory element of a non-volatile memory, wherein a piece of information is written by applying an electric voltage greater in absolute value than a threshold voltage at the ferroelectric material layer.

6. The use of the device according to any of claims 1 to 4, as an element of a programmable logic circuit by applying an electric voltage greater in absolute value than a threshold voltage at the ferroelectric material layer.

7. The use of a device according to any of the claims 1 to 4, as a microswitch by applying an electric voltage greater in absolute value than a threshold voltage at the ferroelectric material layer.
